# EUROPÄISCHE PATENTSCHRIFT

(11) **EP 2 568 855 B1**
(45) Veröffentlichungstag und Bekanntmachung des Hinweises auf die Patenterteilung: **23.04.2014**
(21) Anmeldenummer: 11720297.8
(22) Anmeldetag: 06.05.2011
(51) Int. Cl.: A47C 20/04, A47C 20/08, H03K 17/94, G05B 9/02

(54) **MÖBEL MIT ELEKTROMOTORISCHER VERSTELLEINRICHTUNG**
FURNITURE HAVING AN ELECTROMOTIVE ADJUSTMENT MEANS
MEUBLE POURVU D'UN DISPOSITIF DE RÉGLAGE ÉLECTROMOTORISÉ

(30) Priorität: 08.05.2010 DE 202010005416 U
(43) Veröffentlichungstag der Anmeldung: 20.03.2013
(73) Patentinhaber: DewertOkin GmbH, 32278 Kirchlengern (DE)
(72) Erfinder: HILLE, Armin, 33659 Bielefeld (DE)
(74) Vertreter: Kleine, Hubertus
(86) Internationale Anmeldenummer: PCT/EP2011/057308
(87) Internationale Veröffentlichungsnummer: WO 2011/141375

(56) Entgegenhaltungen:
- EP-A1- 1 125 525
- WO-A1-2007/124748
- DE-U1- 20 119 111
- US-A1- 2010 096 553

## Beschreibung

Die Erfindung betrifft ein ein oder mehrere verstellbare Möbelbauteile enthaltendes Möbel, mit einer elektromotorischen Verstelleinrichtung und einer Sicherheitseinrichtung wobei die elektromotorische Verstelleinrichtung ein Gehäuse, wenigstens einen Antriebsgetriebemotor, eine ein Gehäuse aufweisende Steuereinheit und mit mindestens einer Antriebseinheit, dessen Abtriebsglied mit einem zu verstellenden Möbelbauteil oder mit einem Eingangsglied eines Verstellbeschlages verbunden ist, wobei mittels einer Sicherheitseinrichtung beim Einklemmen zwischen zwei in Wirkverbindung stehenden Möbefbauteilen oder zwischen einem Möbelbauteil und einem anderen Bauteil oder zwischen einem Möbelbauteil und einem Körperteil der Antriebsgetriebemotor stillsetz- und/oder umsteuerbar ist.

Die in Rede stehende elektromotorische Verstelleinrichtung ist in vielen Ausführungen bekannt. Die jeweilige Ausführung richtet sich der Art des zu verstellenden Möbeis, beispielsweise eines Lattenrostes, eines Kranken- oder Pflegebettes oder eines Sitz- und Liegemöbels oder zur Höhenverstellung einer Tischplatte.

Da die Versteilgeschwindigkeiten der zu verstellenden Möbelbauteile relativ gering sind, ist das Getriebe des Antriebsgetriebemotors ein Drehzahlreduziergetriebe, vorzugsweise in Form eines Schneckentriebes. Der Antriebsmotor des Getriebemotors ist ein mit einer Sicherheitsgleichspannung zu betreibender Gleichstrommotor. Die von dem Getriebemotor antreibbare Antriebseinheit ist in bevorzugter Ausführung ein Spindeltrieb, wobei entweder die Spindel rotierend antreibbar ist und eine darauf aufgesetzte, gegen Drehung gesicherte Spindelmutter in Längsrichtung der Spindel bei eingeschaltetem Antriebsgetriebemotor verfährt oder in der Umkehrung, dass die Spindel gegen Drehung gesichert ist und in Längsrichtung verfährt, wobei dann die Spindelmutter verfährt. Mit dem linear bewegbaren Getriebebauteil ist das Abtriebsglied der Antriebseinheit fest verbunden. Dies kann beispielsweise ein Hubrohr sein, welches am freien Ende einen Gabelkopf aufweist, weiches mit dem zu verstellenden Möbelbauteil oder mit dem Eingangsglied eines Verstellbeschlages gelenkig verbunden ist.

Die in Rede stehenden Verstelleinrichtungen sind als Einzel- oder Doppelantriebe bekannt. Bei Einzelantrieben ist mit dem Antriebsgetriebemotor eine Antriebseinheit gekoppelt, während bei einem Doppelantrieb mit einem Getriebemotor oder mit zwei Getriebemotoren gekoppelte Antriebseinheiten vorgesehen sind, die in einem gemeinsamen Gehäuse angeordnet sind.

Andere Verstelleinrichtungen sind als sogenannte Hubsäulen bekannt und stehen mit einem Bauteil eines höhenverstellbaren Tisches, einer höhenverstellbaren Arbeitsfläche oder eines höhenverstellbaren Bettes in Verbindung. Dabei sind die Hubsäulen nach Art eines Einzelantriebes aufgebaut, wobei die Hubsäulen wenigstens einen Spindeltrieb und wenigstens ein ausfahrbares Hubrohr aufweisen, wobei bei einer Anordnung mit mehreren Hubrohren diese nach Art der Führungsrohre ineinander angeordnet sind und mit Führungsmittein aneinander gelagert und untereinander geführt sind.

Die Sicherheitseinrichtung wird in der Branche als Einklemmschutz bezeichnet. Es soll verhindert werden, dass versehentlich Körperteile von Personen oder Haustieren eingeklemmt werden, was zu Verletzungen führen könnte. Da die Verstelleinrichtungen für die Möbel Massenprodukte sind, sollen sie äußerst preiswert herstellbar sein.

Bei bekannten Sicherheitseinrichtungen werden beispielsweise Schaltleisten verwendet, die relativ kostenintensiv sind. Außerdem sind solche Schaltleisten störend. Aus den vorgenannten Gründen werden auch Sicherheitseinrichtungen in die Antriebseinheit oder in den Antriebsgetriebemotor eingebaut. Nachteilig ist jedoch, dass bereits in Betrieb befindende Verstelleinrichtungen nicht nachrüstbar sind.

In der WO 2007/124748 A1 wird ein Krankenhaus- oder Pflegebett mit einem unteren und einem oberen Rahmen beschrieben, der mit dem unteren Rahmen verbunden, jedoch motorisch verstellbar ist. Das Krankenhaus- oder Pflegebett ist mit einer aktivierbaren Sicherheitseinrichtung ausgerüstet, die mit einer Lichtquelle auf der oberen Seite des unteren Rahmens installiert ist, und die Lichtstrahlen zu einem Empfänger ausstrahlt, der mit der Sicherheitseinrichtung verknüpft ist, wobei der Motor abgeschaltet wird, wenn die Lichtstrahlen unterbrochen werden.

Die Lichtquelle und der Empfänger sind unmittelbar nebeneinander positioniert, so dass der Lichtstrahl im Wesentlichen entlang des unteren Rahmens zu dem

Empfänger geleitet wird. Dieser Lichtstrahl wird über die obere Seite des unteren Rahmens geleitet.

Der Erfindung liegt die Aufgabe zugrunde, ein Möbel mit einer elektromotorischen Verstelleinrichtung und einer Sicherheitseinrichtung der eingangs näher beschriebenen Art so auszugestalten, dass die Sicherheitseinrichtung einfach aufgebaut und kostengünstig herstellbar ist, und dass darüber hinaus diese Sicherheitseinrichtung so ausgelegt ist, dass bereits sich in Betrieb befindende elektromotorische Verstelleinrichtungen damit nachgerüstet werden können.

Die gestellte Aufgabe wird gelöst, indem die Sicherheitseinrichtung einen Lichtsender derart aufweist, dass der erzeugte Lichtstrahl auf wenigstens ein zu verstellendes Möbelbauteil oder auf eines mit dem Möbelbauteil in Verbindung stehendes weiteres Bauteil gerichtet ist, und dass der auf das Möbelbauteil oder auf das mit dem Möbelbauteil in Verbindung stehende weitere Bauteil auftreffende Lichtstrahl reflektiert und auf einen Lichtempfänger auftrifft, und dass bei einer durch Verformung des Möbelbauteils bedingten Änderung der reflektierten Lichtintensität mittels eines Signalwandlers elektrische Signale erzeugbar sind, so dass nach der Auswertung dieser Signale durch eine Steuerelektronik der Steuereinheit der Antriebsgetriebemotor stillsetz- und/oder umsteuerbar ist.

Die Sicherheitseinrichtung ist nunmehr als optisches System ausgelegt, so dass durch den Einsatz eines Lichtsenders und eines Lichtempfängers dieses System sehr preiswert ist, und dass damit auch vorhandene elektromotorische Verstelleinrichtungen nachgerüstet werden können. Dieses optische System detektiert berührungslos die Verformung eines Möbelbauteiles, beispielsweise einer Tischplatte. Dabei werden auch die bei einem Einklemmen relativ geringen Verformungen detektiert, so dass dieses System als direkte Verbindung anzusehen ist. Ferner ist diese berührungslose und optische Detektion werkstoffunabhängig.

Besonders vorteilhaft ist, wenn der Lichtsender und der Lichtempfänger in einem Gehäuse angeordnet sind, welches mit dem zu verstellenden Möbelbauteil gekoppelt ist. Dabei ist besonders vorteilhaft, wenn der Lichtsender und der Lichtempfänger im Gehäuse der Steuereinheit installiert sind, da dadurch die Nachrüstbarkeit vorhandener elektromotorischer Verstelleinrichtungen besonders einfach erreicht werden kann.

Zweckmäßigerweise stehen dann die einander zugewandten Flächen des Gehäuses und des Möbelbauteiles in einem relativ geringen Abstand zueinander. Dieser Abstand kann beispielsweise im Bereich von 1 mm liegen, so dass äußerst geringfügige Verformungen des Möbelbauteiles im Falle eines Einklemmens registriert und ausgewertet werden können. Dieser Abstand ist vorzugsweise auch veränderbar, durch eine entsprechende Einstellmöglichkeit. Sofern der Lichtsender und der Lichtempfänger im Steuergehäuse zur Steuerung der elektromotorischen Verstelleinrichtung angeordnet sind, sind die Signalübertragungswege entsprechend kurz. Dabei ist dann das Gehäuse mit entsprechenden Öffnungen für die Lichtstrahlen versehen. Der Lichtsender und der Lichtempfänger können dann auch im Bereich der Platine zur Steuerung der elektromotorischen Verstelleinrichtung angeordnet sein. Die vorstehende Ausführung ist besonders geeignet, wenn das zu verstellende Möbelbauteil eine Tischplatte ist, die durch eine Hubsäule verstellbar ist. Wenn jedoch das Möbelbauteil bzw. die Tischplatte durch mehrere Hubsäulen verstellt wird, ist es besonders vorteilhaft, wenn der Lichtsender und der Lichtempfänger in einem separaten Gehäuse oder in einem weiteren separaten Gehäuse installiert sind, da dann eine Deformierung des Möbelbauteiles ausschließlich zwischen den Säulen erkannt werden kann. In einer bevorzugten Ausführung, wobei die Tischplatte durch zwei Hubsäulen verstellt wird, ist der Lichtsender und der Lichtempfänger im Bereich zwischen den Hubsäulen oder im Bereich neben den Hubsäulen angeordnet, wobei der Lichtsender und der Lichtempfänger in oder an dem Gehäuse zur Steuerung der elektromotorischen Verstelleinrichtung angeordnet ist.

Bei einem Tisch, der aus zwei in einem Winkel aneinander angeordneten und verbundenen Tischplatten besteht oder der eine winkelförmige oder eine bogenförmige Tischplatte aufweist, können mehr als zwei im Abstand zueinander angeordnete Hubsäulen stehen. Dabei können zum Beispiel eine erste Anordnung von Lichtsender und Lichtempfänger in dem Steuerungsgehäuse unter der einen Tischplatte befestigt sein, wobei eine zweite Anordnung von Lichtsender und Lichtempfänger in einem separaten Gehäuse unter der anderen Tischplatte und/oder unter einem anderen Tischplattenabschnitt befestigt sind und über ein Anschlusskabel oder auch eine drahtlose Verbindung mit der Steuerung im Steuerungsgehäuse in Verbindung stehen.

Die Lichtstrahlen können die bekannten Arten sein, wie z.B. kohärent, polarisierend, pulsierend, sichtbar, infrarot und dergleichen. Alternativ können die Lichtwellen auch durch Lichtwellenleiter übertragen werden.

Die Verbindungen des Gehäuses mit dem Möbelbauteil liegen in einem relativ großen Abstand zueinander. Dadurch wird die Registrierung der Verformung besonders genau.

Es ist ferner vorgesehen, dass der von den beiden Lichtstrahlen zur zugewandten Fläche des zu verstellenden Möbelbauteils eingeschlossene jeweilige Winkel ein relativ kleiner spitzer Winkel ist, wodurch das ganze System besonders empfindlich reagieren kann. Dieser Winkel könnte beispielsweise im Bereich von 35 Grad liegen und kann gemäß anderen unterschiedlichen Ausführungsformen in einer Spanne von 15 Grad bis 50 Grad liegen.

Vorteilhaft ist, wenn die von dem Lichtempfänger erzeugten Signale mittels eines Signalwandlers in elektrische Signale umwandelbar und diese Signale in die Steuerelektronik der Steuereinheit einspeisbar sind.

In weiterer Ausgestaltung ist vorgesehen, dass die erzeugten Signale derart gefiltert sind, dass das System nur dann anspricht, wenn eine bestimmten Kontinuität gegeben ist, d.h. bei einer schlagartigen, durch entsprechende Krafteinwirkung erzeugten Verformung spricht das System nicht an. Ein solche Krafteinwirkung wäre beispielsweise, wenn ein Gegenstand aus einer bestimmten Höhe heraus abgesetzt wird, ohne Zurückhaltung, und somit in der Signalkette ein zunächst impulsartiges Signal durch ein nachgeschaltetes Filter in ein gefiltertes Signal umgewandelt wird, was dann in die Steuerelektronik der Steuereinheit zugeführt wird. Die Filterung der Signale erfolgt durch allgemein bekannte Bandpassfilter. Je nach Art der Ausführung des Filters können zeitlich langsame und/oder zeitlich schnelle Änderungen des Signals herausgefiltert werden. Die Grenzfrequenz des jeweiligen Filters ist auf bekannte Art und Weise anpassbar ausgebildet und ist der Verstellgeschwindigkeit des Möbels angepasst. Bei einem verstellbaren Möbel mit einer relativ hohen Verstellgeschwindigkeit ist wenigstens ein Filter vorgesehen, welches zumindest eine relativ niedrige Grenzfrequenz aufweist.

Damit eine Streuung der Lichtstrahlen vermieden wird, ist vorgesehen, dass die Lichtstrahlen durch Lichtleitkanäle geführt werden.

Es ist ferner vorgesehen, dass der Lichtsender eine Infrarotdiode und der Lichtempfänger ein Infrarotfototransistor ist.

In bevorzugter Ausführung ist das zu verstellende Möbelbauteil eine mit mindestens einer Hubsäule zu verstellende Tischplatte. Es sind jedoch auch Tische bekannt, die als sogenannte Winkelkombinationen bezeichnet werden, und mit zwei Tischplatten ausgerüstet sind. Es werden dann zwei zuvor beschriebene Systeme notwendig.

Es ist ausreichend, wenn zur Ermittlung der Verformung des Möbelbauteils ein Lichtempfänger und ein Lichtsender verwendet werden. Es ist jedoch auch möglich, dass mehrere Lichtsender und Lichtempfänger eingesetzt werden.

In einer bevorzugten Ausführungsform ist der erzeugte Lichtstrahl direkt auf das Möbelbauteil oder direkt auf die Tisch platte gerichtet. Gemäß einer anderen Ausführungsform ist mit dem Möbelbauteil ein weiteres Bauteil gekoppelt, welches der Bewegung und der Verformung des Möbelbauteils oder der Tischplatte folgt, wobei als weiteres Bauteil ein aufgeklebtes Element, ein Aufkleber, eine Reflexionsfolie, ein Reflektor oder dergleichen in Frage kommt.

Es ist ferner noch eine Vorrichtung zur Anpassung der Lichtintensität vorgesehen, welche zumindest mit dem Lichtsender oder mit der Steuereinheit in Verbindung steht. Die Lichtintensität des ausgebenden Lichtsenders gleicht sich der Intensität des empfangenden Lichts an. Somit kann in vorteilhafter Weise die Sicherheitseinrichtung mit einer Vielzahl unterschiedlich intensiv reflektierenden Oberflächen in Verbindung gebracht werden. Wird beispielsweise die Sicherheitseinrichtung mit einer reflektionsarmen Oberfläche in Verbindung gebracht, so erkennt eine Steuer- und Auswertelektronik, welche mit dem Lichtempfänger in Verbindung steht, ein durchschnittlich schwaches Signal des Lichtempfängers und verändert die Intensität des lichtsendenden Signals solange, bis dass das Signal am Lichtempfänger einen vorgegebenen durchschnittlichen Wert eingenommen hat. Diese automatische Veränderung erfolgt zeitlich betrachtet sehr langsam. In diesem Zusammenhang sei erwähnt, dass für das Erkennen des Einklemmfalls nicht die am Empfänger vorliegende Lichtintensität ist, sondern dessen Änderung und insbesondere dessen schnelle und/oder plötzliche oder rasch verlaufende Änderung in Form der Änderungsgeschwindigkeit maßgebend ist, welche mittels des o.g. Filters aus dem Signalverlauf des Lichtempfängers herausfilterbar ist.

Wie eingangs beschrieben sind Lichtsender und Lichtempfänger in einem Gehäuse angeordnet. In einer weiteren vorteilhaften Ausführungsform ist eine Halterung vorgesehen, die als eine Art Detektorhalterung bezeichnet werden kann, und welche in einer weiteren Ausgestaltung auch als ein Gehäuse ausgebildet sein kann. Es handelt sich vorzugsweise um ein Element oder um eine Anzahl von Elementen, an welchem oder an welchen der Lichtsender und/oder der Lichtempfänger festlegbar und montierbar angeordnet sind. In einer bevorzugten Ausführungsform der Detektorhalterung besteht diese aus zwei spiegelbildlich gestalteten Bauteilen mit halbschalenartigen Ausnehmungen, welche zumindest die Lichtleitkanäle und/oder die Aufnahmen des Lichtsenders bzw. des Lichtempfängers bilden. Gemäß einer alternativen Ausführungsform besteht die Detektorhalterung zumindest aus einem Körper und kann in einer anderen weiterführenden Ausführungsform mit einem Deckel verschlossen sein. Die Detektorhalterung weist in vorteilhafter Weise die Lichtleitkanäle und die Aufnahmen für Lichtsender und/oder Lichtempfänger derart auf, dass der Lichtsender und/oder Lichtempfänger mit der damit montierten Detektorhalterung eine vormontierbare Baueinheit bildet, so dass der Lichtsender und der Lichtempfänger in einem vorgegebenen Abstand zueinander ausgerichtet und angeordnet sind. Die so gebildete Detektoreinheit kann dann in ein Gehäuse in Form eines Steuergehäuses, eines Handschaltergehäuses oder eines separaten Gehäuses eingesetzt und darin montiert werden.

Anhand der beiliegenden Zeichnung wird die Erfindung noch näher erläutert.

Es zeigt:

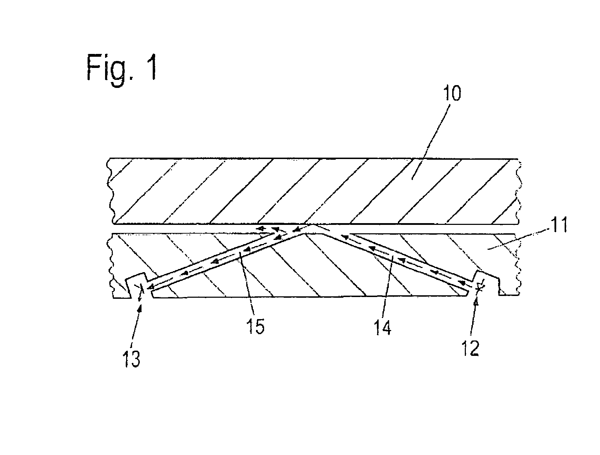

- Figur 1: das optische System einer elektromotorischen Verstelleinrichtung eines Möbels nach der Erfindung, rein schematisch.

Anhand der Figur wird das optische System anhand eines zu verstellenden Möbelbauteiles in Form einer Tischplatte 10 erläutert. Diese Tischplatte 10 ist andeutungsweise dargestellt. An der unteren Seite der Tischplatte 10 ist ein andeutungsweise dargestelltes Gehäuse 11 festgelegt. Dieses Gehäuse 11 kann das Gehäuse der Steuereinheit oder auch ein separates Gehäuse sein. Sofern es sich bei dem Möbel um eine sogenannte Winkelkombination handelt, ist unter jeder Tischplatte oder bei winkelförmigen oder bei bogenförmigen Tischplatten unter jedem Tischplattenabschnitt ein Gehäuse angeordnet. In diesem Gehäuse 11 ist im der Tischplatte 10 abgewandten Bereich ein Lichtsender in Form einer Infrarotdiode 11 installiert. Im Abstand dazu und höhengleich ist ein Lichtempfänger in Form eines Infrarotfototransistors 13 installiert. Wie die Figur zeigt, steht das Gehäuse 11 in einem relativ geringen Abstand zur Unterseite der Tischplatte 10. Dieser Abstand liegt beispielsweise im Bereich von 1 mm. Das Gehäuse 11 ist mit zwei Lichtleitkanälen 14, 15 versehen, die unter einem stumpfen Winkel zueinander stehen. An den der Tischplatte 10 abgewandten Seiten sind die Infrarotdiode 12 und der Infrarotfototransistor 13 installiert. Der von der Infrarotdiode 12 gesendete Lichtstrahl trifft auf die Unterseite der Tischplatte 10 auf, und wird dort reflektiert und von dem Infrarotfototransistor 13 empfangen. Der von der der Tischplatte 10 zugewandten Fläche des Gehäuses 11 und den Lichtleitkanälen 14, 15 eingeschlossene Winkel ist ein relativ kleiner spitzer Winkel, beispielsweise im Bereich von 20 Grad. Der Winkel ist als spitzer Winkel ausgebildet, was die Empfindlichkeit des optischen Systems in vorteilhafter Weise stark vergrößert.

Kommt es während des Verstellvorganges des Möbelbauteiles, im dargestellten Ausführungsbeispiel der Tischplatte 10, zu einem Einklemmvorgang, beispielsweise eines Körperteiles, wird die Tischplatte 10 verformt, wobei diese Verformung nicht sichtbar ist. Durch die Empfindlichkeit des optischen Systems ändert sich jedoch durch die rasche bzw. durch die plötzlich geänderte Reflektion der Lichtstrahlen die Lichtintensität. Diese Änderung wird mittels eines Signalwandlers in elektrische Signale umgewandelt, so dass durch eine Steuerelektronik der Steuereinheit der Antriebsgetriebemotor entweder stillgesetzt oder kurzfristig umgeschaltet wird, d.h. die Drehrichtung wird geändert.

Die Signale werden gefiltert, beispielsweise mittels eines Bandbassfilters, so dass das System das Stillsetzen oder die Umsteuerung des Antriebsgetriebemotors nur dann eingeleitet wird, wenn nach einer Kontinuität eine Änderung erfolgt, vorzugsweise eine rasche oder plötzliche Änderung erfolgt. Wird die Tischplatte 10 jedoch schlagartig belastet, beispielsweise durch Absetzen eines relativ schweren Gegenstandes, liegt in der Signalkette ein impulsartiges Signal vor, welches durch einen Bandpassfilter herausgefiltert wird und es spricht das System nicht an.

Die Erfindung ist nicht auf das dargestellte Ausführungsbeispiel beschränkt. Wesentlich ist, dass in einem Gehäuse 11 mindestens ein Lichtsender 12 und eine entsprechende Anzahl von Lichtempfängern 13 installiert sind.

Bei Oberflächen, deren Reflexionsvermögen mit dem Lichtsender und Lichtempfänger keinen ausreichenden Wirkeffekt erzeugt, kann der Flächenabschnitt, welcher zur Reflexion angestrahlt wird, mit einer geeigneten Reflexionsfolie oder dergleichen ausgestattet werden, zum Beispiel mit einer Selbstklebefolie.

Es sei noch der besondere Vorteil des voreingestellten Abstandes zwischen der Tischplatte 10 und dem Gehäuse 11 erläutert. Das Gehäuse 11 wird in einem festen Abstand von beispielsweise 1...5 mm zur Tischplatte 10 gehalten, was in einer Ausführungsform durch angesetzte Abstandshalter, in einer zweiten Ausführungsform durch an dem Gehäuse 11 angeformte Abstandshalter und in einer weiteren Ausführungsform durch ein gebogen oder gewölbt geformtes Gehäuse realisiert wird. Dabei sind die Abstandshalter im Bereich der Anschraubpunkte und Befestigungsschrauben angeordnet, so dass das Gehäuse 11 im Bereich der Befestigungspunkte an der Tischplatte 10 anliegt, womit das Gehäuse 11 an das Möbel, an das Möbelbauteil oder an die Tischplatte 10 angeschraubt ist. Die freien Enden der Lichtleitkanäle 14, 15, welche dadurch definiert sind, dass sie dem Lichtsender 12 bzw. dem Lichtempfänger 13 gegenüberliegend angeordnet sind, sind in einem möglichst großen Abstand zu den Anschraubpunkten angeordnet. Beispielsweise bei einer Verformung der Tischplatte 10 ändert sich der Abstand zwischen Tischplatte 10 und Gehäuse 11 stärker als in der Nähe der Anschraubpunkte, so dass die Messempfindlichkeit bei einer Anordnung der Lichtleitkanäle 14, 15 mit größer werdendem Abstand zu den Anschraubpunkten vorteilhaft vergrößert wird. Das Gehäuse 11 ist dabei relativ verformungssteif ausgebildet, d.h. es ist verformungssteifer als die Tischplatte 10.

## Patentansprüche

1. Ein oder mehrere verstellbare Möbelbauteile (10) enthaltendes Möbel, mit einer elektromotorischen Verstelleinrichtung und einer Sicherheitseinrichtung wobei die elektromotorische Verstelleinrichtung ein Gehäuse, wenigstens einen Antriebsgetriebemotor, eine ein Gehäuse aufweisende Steuereinheit und mit mindestens einer Antriebseinheit, dessen Abtriebsglied mit einem zu verstellenden Möbelbauteil oder mit einem Eingangsglied eines Verstellbeschlages verbunden ist, wobei mittels einer Sicherheitseinrichtung beim Einklemmen zwischen zwei in Wirkverbindung stehenden Möbelbauteilen oder zwischen einem Möbelbauteil und einem anderen Bauteil oder zwischen einem Möbelbauteil und einem Körperteil der Antriebsgetriebemotor stillsetz- und/oder umsteuerbar ist, **dadurch gekennzeichnet, dass** die Sicherheitseinrichtung einen Lichtsender (12) derart aufweist, dass der erzeugte Lichtstrahl auf wenigstens ein zu verstellendes Möbelbauteil (10) oder auf eines mit dem Möbelbauteil (10) in Verbindung stehenden weiteren Bauteils gerichtet ist, und dass der auf das Möbelbauteil (10) oder auf das mit dem Möbelbauteil (10) in Verbindung stehenden weiteren Bauteil auftreffende Lichtstrahl reflektiert und auf einen Lichtempfänger (13) auftrifft, so dass bei einer durch Verformung des Möbelbauteils (10) bedingten Änderung der reflektierten Lichtintensität mittels eines Signalwandlers elektrische Signale erzeugbar sind, so dass nach der Auswertung dieser Signale durch eine Steuerelektronik der Steuereinheit der Antriebsgetriebemotor stillsetz- und/oder umsteuerbar ist.

2. Ein oder mehrere verstellbare Möbelbauteile enthaltendes Möbel nach Anspruch 1, **dadurch gekennzeichnet, dass** der Lichtsender (12) und der Lichtempfänger (13) innerhalb eines Gehäuses (11) angeordnet sind, welches mit dem zu verstellenden Möbelbauteil gekoppelt ist.

3. Ein oder mehrere verstellbare Möbelbauteile enthaltendes Möbel nach einem oder mehreren der vorstehenden Ansprüche, **dadurch gekennzeichnet, dass** in dem Gehäuse (11) zwei unter einem stumpfen Winkel zueinander stehende Lichtleitkanäle (14, 15) vorgesehen sind.

4. Ein oder mehrere verstellbare Möbelbauteile enthaltendes Möbel nach Anspruch 3, **dadurch gekennzeichnet, dass** eine Halterung vorgesehen ist, welche die Lichtleitkanäle (14, 15) und Aufnahmen für den Lichtsender (12) und/oder den Lichtempfänger (13) aufweist.

5. Ein oder mehrere verstellbare Möbelbauteile enthaltendes Möbel nach Anspruch 4, **dadurch gekennzeichnet, dass** die Halterung mit dem darin aufgenommenen Lichtsender (12) und/oder Lichtempfänger (13) eine vormontierbare Baueinheit derart bildet, dass der Lichtsender (12) und der Lichtempfänger (13) in einem vorgegebenen Abstand zueinander ausgerichtet und angeordnet sind.

6. Ein oder mehrere verstellbare Möbelbauteile enthaltendes Möbel nach Anspruch 5, **dadurch gekennzeichnet, dass** die Halterung mit dem darin aufgenommenen Lichtsender (12) und/oder Lichtempfänger (13) als vormontierbare Baueinheit in dem Gehäuse (11) montierbar ist oder mit dem Gehäuse (11) einstückig ausgebildet ist.

7. Ein oder mehrere verstellbare Möbelbauteile enthaltendes Möbel nach einem oder mehreren der Ansprüche 2 bis 6, **dadurch gekennzeichnet, dass** das Gehäuse (11) ein separates Gehäuse oder das Gehäuse der Steuereinheit ist, und dass der Lichtsender (12) und der Lichtempfänger (13) im Bereich einer Steuerplatine der Steuereinheit installiert sind.

8. Ein oder mehrere verstellbare Möbelbauteile enthaltendes Möbel nach einem oder mehreren der Ansprüche 2 bis 7, **dadurch gekennzeichnet, dass** das Gehäuse (31) in einem festen Abstand zur dem Möbelbauteil (10) oder zu dem mit dem Möbelbauteil (10) in Verbindung stehenden weiteren Bauteil durch angesetzte Abstandshalter gehalten ist, oder durch an dem Gehäuse (11) angeformte Abstandshalter gehalten ist, oder durch ein gebogen oder gewölbt geformtes Gehäuse realisiert ist.

9. Ein oder mehrere verstellbare Möbelbauteile enthaltendes Möbel nach Anspruch 8, **dadurch gekennzeichnet, dass** die Abstandshalter im Bereich von Anschraubpunkten beziehungsweise im Bereich von Befestigungspunkten des Gehäuses (11) angeordnet sind.

10. Ein oder mehrere verstellbare Möbelbauteile enthaltendes Möbel nach Anspruch 9, **dadurch gekennzeichnet, dass** die freien Enden der Lichtleitkanäle (14, 15), welche dadurch definiert sind, dass sie dem Lichtsender (12) und/oder dem Lichtempfänger (13) gegenüberliegend angeordnet sind, in einem großen Abstand zu den Anschraubpunkten angeordnet sind.

11. Ein oder mehrere verstellbare Möbelbauteile enthaltendes Möbel nach einem oder mehreren der vorstehenden Ansprüche, **dadurch gekennzeichnet, dass** der von dem Lichtsender (12) erzeugte Lichtstrahl ein kohärenter, polarisierender, pulsierender, sichtbarer oder ein Lichtstrahl auf Infrarotbasis ist.

12. Ein oder mehrere verstellbare Möbelbauteile enthaltendes Möbel nach einem oder mehreren der vorstehenden Ansprüche, **dadurch gekennzeichnet, dass** die Übertragung der Lichtstrahlen durch einen Lichtwellenleiter erfolgt.

13. Ein oder mehrere verstellbare Möbelbauteile enthaltendes Möbel nach einem oder mehreren der vorstehenden Ansprüche, **dadurch gekennzeichnet, dass** das Gehäuse (11) in sich formstabil ist, und dass die einander zugewandten Flächen des zu verstellenden Möbelbauteiles (10) und des Gehäuses (11) in einem relativ geringen Abstand zueinander stehen.

14. Ein oder mehrere verstellbare Möbelbauteile enthaltendes Möbel nach einem oder mehreren der vorstehenden Ansprüche, **dadurch gekennzeichnet, dass** die von dem Lichtsender (12) und dem Lichtempfänger (13) empfangenen Lichtstrahlen unter einem spitzen Winkel zur zugeordneten Fläche des zu verstellenden Möbelbauteils (10) stehen.

15. Ein oder mehrere verstellbare Möbelbauteile enthaltendes Möbel nach einem oder mehreren der vorstehenden Ansprüche, **dadurch gekennzeichnet, dass** die von dem Lichtempfänger (13) erzeugten Signale mittels eines Signalwandlers in elektrische Signale umwandelbar und diese Signale in die Steuerelektronik der Steuereinheit einspeisbar sind.

16. Ein oder mehrere verstellbare Möbelbauteile enthaltendes Möbel nach Anspruch 15, **dadurch gekennzeichnet, dass** die Signale filterbar sind, vorzugsweise mittels eines Bandpassfilters.

17. Ein oder mehrere verstellbare Möbelbauteile enthaltendes Möbel nach einem oder mehreren der vorstehenden Ansprüche in Form einer Winkelkombination, **dadurch gekennzeichnet, dass** jeder ischplatte der Winkelkombination mindestens ein Lichtsender (12) und wenigstens ein Lichtempfänger (13) zugeordnet ist.

18. Ein oder mehrere verstellbare Möbelbauteile enthaltendes Möbel nach einem oder mehreren der vorstehenden Ansprüche, **dadurch gekennzeichnet, dass** der Lichtsender eine Infrarotdiode (12) und der Lichtempfänger ein Infrarotfototransistor (13) ist.

## Claims

1. Item of furniture, containing one or more adjustable furniture components (10), having an adjustment device driven by an electric motor and a safety device, wherein the adjustment device driven by an electric motor has a housing, at least one drive gear motor, a control unit having a housing and at least one drive unit, the driven element of which is connected to a furniture component to be adjusted or to an input element of an adjustment fitting, wherein a safety device can be used to shut down and/or reverse the drive gear motor in the event that something becomes jammed between two operatively connected furniture components or between a furniture component and another component or between a furniture component and a body part, **characterized in that** the safety device has a light transmitter (12) such that the generated light beam is directed onto at least one furniture component (10) to be adjusted or onto a further component connected to the furniture component (10), and **in that** the light beam impinging on the furniture component (10) or on the further component that is connected to the furniture component (10) is reflected and impinges on a light receiver (13), such that, if a change in the reflected light intensity occurs on account of the furniture component (10) being deformed, electrical signals can be generated by means of a signal transducer such that, after said signals have been evaluated by control electronics of the control unit, the drive gear motor can be shut down and/or reversed.

2. Item of furniture, containing one or more adjustable furniture components, according to Claim 1, **characterized in that** the light transmitter (12) and the light receiver (13) are arranged inside a housing (11), which is coupled with the furniture component to be adjusted.

3. Item of furniture, containing one or more adjustable furniture components, according to one or more of the preceding claims, **characterized in that** two light-guide channels (14, 15), which are at an obtuse angle with respect to one another, are provided in the housing (11).

4. Item of furniture, containing one or more adjustable furniture components, according to Claim 3, **characterized in that** a holder is provided, which has the light-guide channels (14, 15) and receptacles for the light transmitter (12) and/or the light receiver (13).

5. Item of furniture, containing one or more adjustable furniture components, according to Claim 4, **characterized in that** the holder forms a pre-assemblable structural unit with the light transmitter (12) and/or light receiver (13), which are held in said holder, such that the light transmitter (12) and the light receiver (13) are aligned and arranged at a predetermined spacing with respect to one another.

6. Item of furniture, containing one or more adjustable furniture components, according to Claim 5, **characterized in that** the holder is mountable in the housing (11) with the light transmitter (12) and/or light receiver (13), which are held in said holder, as a pre-assemblable structural unit or is configured in one piece with the housing (11).

7. Item of furniture, containing one or more adjustable furniture components, according to one or more of Claims 2 to 6, **characterized in that** the housing (11) is a separate housing or the housing of the control unit, and **in that** the light transmitter (12) and the light receiver (13) are mounted in the region of a control board of the control unit.

8. Item of furniture, containing one or more adjustable furniture components, according to one or more of Claims 2 to 7, **characterized in that** the housing (11) is held at a fixed distance from the furniture component (10) or from the further component connected to the furniture component (10) using attached spacers, or is held using spacers which are integrally formed on the housing (11), or is realized by an arced or convex housing.

9. Item of furniture, containing one or more adjustable furniture components, according to Claim 8, **characterized in that** the spacers are arranged in the region of screw connection points or in the region of attachment points of the housing (11).

10. Item of furniture, containing one or more adjustable furniture components, according to Claim 9, **characterized in that** the free ends of the light-guide channels (14, 15), which are defined by the fact that they are arranged opposite the light transmitter (12) and/or the light receiver (13), are arranged at a great distance from the screw connection points.

11. Item of furniture, containing one or more adjustable furniture components, according to one or more of the preceding claims, **characterized in that** the light beam generated by the light transmitter (12) is a coherent, polarizing, pulsing, visible or infrared-based light beam.

12. Item of furniture, containing one or more adjustable furniture components, according to one or more of the preceding claims, **characterized in that** the light beams are transmitted using an optical waveguide.

13. Item of furniture, containing one or more adjustable furniture components, according to one or more of the preceding claims, **characterized in that** the housing (11) is dimensionally stable in itself, and **in that** the mutually facing surfaces of the furniture component (10) to be adjusted and of the housing (11) are located at a relatively small distance from one another.

14. Item of furniture, containing one or more adjustable furniture components, according to one or more of the preceding claims, **characterized in that** the light beams received from the light transmitter (12) and by the light receiver (13) are at an acute angle with respect to the associated surface of the furniture component (10) to be adjusted.

15. Item of furniture, containing one or more adjustable furniture components, according to one or more of the preceding claims, **characterized in that** the signals generated by the light receiver (13) are convertible into electrical signals using a signal transducer and said signals are injectable into the control electronics of the control unit.

16. Item of furniture, containing one or more adjustable furniture components, according to Claim 15, **characterized in that** the signals are filterable, preferably using a bandpass filter.

17. Item of furniture, containing one or more adjustable furniture components, according to one or more of the preceding claims in the form of an angle combination, **characterized in that** each table top of the angle combination is assigned at least one light transmitter (12) and at least one light receiver (13).

18. Item of furniture, containing one or more adjustable furniture components, according to one or more of the preceding claims, **characterized in that** the light transmitter is an infrared diode (12) and the light receiver is an infrared phototransistor (13).

## Revendications

1. Meuble comportant un ou plusieurs élément(s) de meuble réglable(s) (10) comportant un dispositif de réglage électromoteur ainsi qu'un dispositif de sécurité, le dispositif de réglage électromoteur comportant un boitier, au moins un motoréducteur d'entrainement, une unité de commande comportant un boitier, ainsi qu'au moins une unité d'entrainement dont l'organe de sortie est relié à un élément de meuble à régler ou à un organe d'entrée d'une fixation réglable, le dispositif de sécurité permettant, lors d'un blocage entre deux éléments de meuble en liaison de fonctionnelle, ou entre un élément de meuble et un autre élément, ou entre un élément de meuble et un élément de corps de mettre à l'arrêt et/ou d'inverser le motoréducteur d'entrainement, **caractérisé en ce que**
le dispositif de sécurité comporte un émetteur de lumière (12) dont le faisceau lumineux émis est dirigé sur au moins un élément de meuble (10) à régler ou sur un autre élément se trouvant en liaison avec l'élément de meuble (10), et le faisceau lumineux frappant l'élément de meuble (10) ou l'autre élément se trouvant en liaison avec l'élément de meuble (10) est réfléchi et frappe un récepteur lumineux (13), de sorte que, en présence d'une modification de l'intensité lumineuse réfléchie conditionnée par une déformation de l'élément de meuble (10), des signaux électriques puissent être générés par un convertisseur de signal, pour que, suite à l'exploitation de ces signaux par une électronique de commande le motoréducteur d'entrainement puisse être mis à l'arrêt et/ou inversé.

2. Meuble comportant un ou plusieurs élément(s) de meuble réglable(s) conforme à la revendication 1,
**caractérisé en ce que**
l'émetteur de lumière (12) et le récepteur de lumière (13) sont montés dans un boitier (11) qui est accouplé à l'élément de meuble devant être réglé.

3. Meuble comportant un ou plusieurs élément(s) de meuble réglable(s) selon une ou plusieurs des revendications précédentes,
**caractérisé en ce que**
dans le boitier (11) sont prévus deux canaux de guidage de la lumière (14, 15) faisant un angle obtus l'un par rapport à l'autre.

4. Meuble comportant un ou plusieurs élément(s) de meuble réglable(s) conforme à la revendication 3,
**caractérisé en ce qu'**
il est prévu des moyens de fixation qui comportent les canaux de guidage de la lumière (14, 15) et des organes de réception de l'émetteur de lumière (12) et/ou du récepteur de lumière (13).

5. Meuble comportant un ou plusieurs élément(s) de meuble réglable(s) conforme à la revendication 4,
**caractérisé en ce que**
les moyens de fixation forment avec l'émetteur de lumière (12) et/ou le récepteur de lumière (13) logé(s) dans ceux-ci une unité modulaire pouvant être pré-montée de sorte que l'émetteur de lumière (12) et le récepteur de lumière (13) soient orientés et montés à une distance prédéfinie l'un par rapport à l'autre.

6. Meuble comportant un ou plusieurs élément(s) de meuble réglable(s) conforme à la revendication 5,
**caractérisé en ce que**
les moyens de fixation équipés de l'émetteur de lumière (12) et/ou du récepteur de lumière (13) logé(s) dans ceux-ci peuvent être montés sous la forme d'une unité modulaire pouvant être montée préalablement dans le boitier (11) ou sont réalisés en une seule pièce avec ce boitier (11).

7. Meuble comportant un ou plusieurs élément(s) de meuble réglable(s) conforme à l'une ou plusieurs des revendications 2 à 6,
**caractérisé en ce que**
le boitier (11) est constitué par un boitier séparé ou par le boitier de l'unité de commande, et l'émetteur de lumière (12) et le récepteur de lumière (13) sont installés dans la zone d'une platine de commande de l'unité de commande.

8. Meuble comportant un ou plusieurs élément(s) de meuble réglable(s) conforme à l'une ou plusieurs des revendications 2 à 7,
**caractérisé en ce que**
le boitier (11) est maintenu à une distance fixe de l'élément de meuble (10) ou de l'autre élément relié à l'élément de meuble (10) par les éléments d'écartement prévus à cet effet, ou par des éléments d'écartement formés sur le boitier (11) ou est réalisé sous la forme d'un boitier incurvé ou en forme de voute.

9. Meuble comportant un ou plusieurs élément(s) de meuble réglable(s) conforme à la revendication 8,
**caractérisé en ce que**
les éléments d'écartement sont montés dans la zone de points de vissage ou dans la zone de points de fixation du boitier (11).

10. Meuble comportant un ou plusieurs élément(s) de meuble réglable(s) conforme à la revendication 9,
**caractérisé en ce que**
les extrémités libres des canaux de guidage de la lumière (14, 15) qui sont définies de sorte qu'elles soient situées à l'opposé de l'émetteur de lumière (12) et/ou du récepteur de lumière (13) sont situées à distance importante des points de vissage.

11. Meuble comportant un ou plusieurs élément(s) de meuble réglable(s) conforme à l'une ou plusieurs des revendications précédentes, **caractérisé en ce que**
le faisceau lumineux émis par l'émetteur de lumière (12) est un faisceau de lumière cohérente, polarisée, pulsée, visible, ou à base d'infrarouges.

12. Meuble comportant un ou plusieurs élément(s) de meuble réglable(s) conforme à l'une ou plusieurs des revendications précédentes, **caractérisé en ce que**
la transmission des faisceaux lumineux s'effectue par un guide d'ondes.

13. Meuble comportant un ou plusieurs élément(s) de meuble réglable(s) conforme à l'une ou plusieurs des revendications précédentes, **caractérisé en ce que**
le boitier (11) a intrinsèquement une forme stable et les faces tournées l'une vers l'autre de l'élément de meuble (10) à régler et du boitier (11) sont situées à une distance relativement faible l'une de l'autre.

14. Meuble comportant un ou plusieurs élément(s) de meuble réglable(s) conforme à l'une ou plusieurs des revendications précédentes, **caractérisé en ce que**
les faisceaux lumineux émis par l'émetteur de lumière (12) et reçus par le récepteur de lumière (13) font un angle aigu par rapport à la face associée de l'élément de meuble (10) à régler.

15. Meuble comportant un ou plusieurs élément(s) de meuble réglable(s) conforme à l'une ou plusieurs des revendications précédentes, **caractérisé en ce que**
les signaux produits par le récepteur de lumière (13) peuvent être transformés en signaux électriques par un convertisseur de signal, et ces signaux peuvent être fournis à l'électronique de commande de l'unité de commande.

16. Meuble comportant un ou plusieurs élément(s) de meuble réglable(s) conforme à la revendication 15,
**caractérisé en ce que**
les signaux peuvent être filtrés, de préférence par un filtre passe-bande.

17. Meuble comportant un ou plusieurs élément(s) de meuble réglable(s) selon l'une ou plusieurs des revendications précédentes, réalisé sous la forme d'une combinaison angulaire,
**caractérisé en ce qu'**
à chaque tablette de la combinaison angulaire est associé au moins un émetteur de lumière (12) et au moins un récepteur de lumière (13).

18. Meuble comportant un ou plusieurs élément(s) de meuble réglable(s) conforme à l'une ou plusieurs des revendications précédentes **caractérisé en ce que**
l'émetteur de lumière est une diode infrarouge (12) et le récepteur de lumière est un phototransistor infrarouge (13).
